# DEMANDE DE BREVET EUROPEEN

(11) **EP 4 387 089 A1**
(43) Date de publication de la demande: **19.06.2024**
(21) Numéro de dépôt: 23216957.3
(22) Date de dépôt: 15.12.2023
(51) Int. Cl.: H03B 27/00, H03L 7/24, H03B 9/14, H03K 3/03, H03C 3/00, H03C 3/30, H03B 5/18

(54) **SYSTÈME DE GÉNÉRATION D AU MOINS UN SIGNAL RADIOFRÉQUENCES VERROUILLÉ EN PHASE SUR UN SIGNAL DE RÉFÉRENCE, ÉMETTEUR ET RÉCEPTEUR RADIOFRÉQUENCES CORRESPONDANTS**

(30) Priorité: 16.12.2022 FR 2213592
(71) Demandeur: Commissariat à l'énergie atomique et aux énergies alternatives, 75015 Paris (FR)
(72) Inventeur: MARTINEAU, Baudouin, 38054 GRENOBLE CEDEX 09 (FR); MORCHE, Dominique, 38054 GRENOBLE CEDEX 09 (FR)
(74) Mandataire: Brevalex

(57) **Abrégé**

L'invention concerne un système (100) de génération d'un signal radiofréquences verrouillé en phase sur un signal de référence. Un tel système comprend :
- un oscillateur (110) rotatif à ondes progressives comprenant un anneau (112a, 112b) conducteur et une pluralité de cellules amplificatrices (111a, 111b, 111c, 111d, 111e, 111f, 111g, 111h) d'entretien connectées électriquement à l'anneau ;
- un dispositif multiplexeur (120) programmable configuré pour connecter électriquement un port d'entrée (121) du système à une cellule amplificatrice sélectionnable parmi les cellules de la pluralité.

Le système est configuré pour que l'oscillateur génère le signal radiofréquences verrouillé lorsque le signal de référence est injecté sur le port d'entrée du système. Un écart de phase entre le signal radiofréquences et le signal de référence est fonction de la cellule amplificatrice à laquelle le port d'entrée est électriquement connecté via la programmation du dispositif multiplexeur.

## Description

### Domaine de l'invention

Le domaine de l'invention est celui de la génération de signaux radiofréquences verrouillés en phase.

L'invention se rapporte plus particulièrement à un système de génération d'un tel signal.

Un tel signal est utilisé dans de nombreux domaines liés à la transmission de données, e.g. par liens radiofréquences, acoustique ou optique, notamment pour la génération d'horloges synchrones ou pour la transposition en fréquences. L'invention a ainsi des applications, notamment, mais non exclusivement, dans le domaine de la téléphonie mobile (e.g. réseaux 4G, 5G ou au-delà tels que définis par le 3GPP (pour « 3rd Génération Partnership Project » en anglais)) ou des réseaux locaux sans fil WLAN (pour « Wireless Local Area Network » en anglais, e.g. utilisant le WiFi), l'accès internet sans fil à haut débit (WiMAX), les liaisons numériques asymétriques (xDSL), etc.

### Art antérieur et ses inconvénients

On s'attache plus particulièrement dans la suite de ce document à décrire une problématique existante pour la formation de faisceau dans le domaine de la transmission de données par lien radiofréquences. L'invention ne se limite bien sûr pas à cette application particulière, mais présente un intérêt pour toutes les applications dans lesquelles un signal verrouillé en phase est utilisé (e.g. pour la génération d'horloges synchrones).

La formation de faisceau, technique utilisée notamment dans les normes cellulaires 5G et au-delà, permet de mieux concentrer l'énergie transmise. Similairement à la lumière d'une ampoule que l'on vient focaliser avec un réflecteur, cette technique permet d'atteindre des distances plus grandes et focalise le faisceau directement vers l'utilisateur et non plus de manière omnidirectionnelle.

Un tel résultat est obtenu via la subdivision d'un émetteur en un réseau de chaines d'émission, chaque chaine d'émission étant connectée à des antennes unitaires et ayant la faculté de moduler la phase des signaux émis. La même approche peut être mise en oeuvre en réception.

Pour ce faire, une approche souvent suivie est d'appliquer un déphasage au signal utilisé pour la transposition en fréquence, i.e. au signal communément appelé LO (pour « Local Oscillator » en anglais), avant qu'il ne soit appliqué aux différents mélangeurs des chaines d'émission. Cette technique s'applique aussi bien pour la transposition en fréquences depuis les fréquences basses vers la fréquence d'émission pour un émetteur, ou depuis la fréquence de réception vers les fréquences basses pour un récepteur.

Afin de déphaser un tel signal LO qui se situe dans les bandes de fréquences radiofréquences, différentes techniques sont connues. A titre d'exemple, on peut citer certaines techniques basées sur l'utilisation de déphaseurs passifs, notamment :
- une technique de déphaseur passif basée sur l'implémentation d'un filtre LC passe-haut et d'un filtre LC passe-bas que l'on vient commuter alternativement (déphaseur dit « Switched Type Phase Shifter » dans la littérature anglo-saxonne). Cependant, bien que de telles topologies de déphaseurs aient montré leur faisabilité, les performances restent limitées. En effet, les déphaseurs doivent être cascadés pour réaliser la fonction de déphasage désirée. Par exemple, un déphaseur couvrant 360 degrés avec des pas de 22.5 degrés nécessite une succession de 4 étages induisant des pertes élevées et une bande passante réduite ;
- une autre technique de déphaseur passif basée sur la commutation entre des lignes de transmission de différentes longueurs électriques par pas discrets ou, alternativement, sur la commutation de composants localisés pour moduler la charge capacitive de la ligne (déphaseur dit « Loaded-line phase shifter » dans la littérature anglo-saxonne). La plage de déphasage obtenue est cependant limitée, généralement inférieure à 45 degrés ;
- encore une autre technique de déphaseur passif basée sur la mise en oeuvre d'un coupleur à 90 degrés chargé par une charge variable (déphaseur dit « Reflection Type Phase Shifter » dans la littérature anglo-saxonne). Plus particulièrement, le coupleur en quadrature divise le signal d'entrée en une partie traversant et une partie couplée avec des déphasages de 0 degrés et 90 degrés. Les signaux réfléchis par les charges sont combinés en phase à la sortie (sur le port isolé) donnant le signal avec la phase désirée. La plage de déphasage totale d'un tel déphaseur est déterminée par la plage de phase réalisable à partir du coefficient de réflexion produit par le réglage de la charge. Or, la plage de variation d'une telle charge ne peut être infinie et ce type de coupleur souffre généralement d'une couverture incomplète du cercle trigonométrique et/ou d'une bande passante limitée puisque les 90 degrés du coupleur n'existent qu'à une fréquence donnée (lié à la dimension physique du coupleur vs la longueur d'onde). Alternativement, certaines techniques connues sont basées sur l'utilisation de déphaseurs actifs (également appelés modulateurs de vecteurs). Contrairement aux déphaseurs passifs, les déphaseurs actifs peuvent fournir du gain et une haute résolution de phase mais souffrent de non-linéarités, de bruit élevé et consomment de l'énergie. Par ailleurs, l'amplitude du signal obtenu par de tels déphaseurs actifs varie souvent en fonction de la phase du signal en question.

Il existe ainsi un besoin pour une technique permettant d'obtenir un signal présentant un déphasage programmable sur une large gamme, idéalement sur l'ensemble du cercle trigonométrique. Il existe un besoin pour qu'une telle technique présente des pertes limitées et délivre un signal d'amplitude constante.

### Exposé de l'invention

Dans un mode de réalisation de l'invention, il est proposé un système de génération d'un (ou plusieurs) signal radiofréquences verrouillé en phase sur un signal de référence. Un tel système comprend :
- un oscillateur rotatif à ondes progressives comprenant au moins un anneau conducteur et une pluralité de cellules amplificatrices d'entretien connectées électriquement audit au moins un anneau, une longueur radioélectrique de l'anneau chargé par une impédance des cellules amplificatrices correspondant à une fréquence du (ou des) signal radiofréquences ;
- un dispositif multiplexeur programmable configuré pour connecter électriquement un port d'entrée du système à au moins une cellule amplificatrice sélectionnable parmi les cellules de la pluralité.

Le système est configuré pour que l'oscillateur génère un signal d'oscillation verrouillé en phase sur le signal de référence lorsque le signal de référence est injecté sur le port d'entrée du système. Un écart de phase entre le signal d'oscillation et le signal de référence est fonction de ladite au moins une cellule amplificatrice à laquelle le port d'entrée est électriquement connecté via la programmation du dispositif multiplexeur. Le (ou les) signal radiofréquences correspond au signal d'oscillation prélevé en un point donné respectif dudit au moins un anneau.

Ainsi, l'invention propose une solution nouvelle et inventive pour la génération d'un (ou plusieurs) signal radiofréquences (e.g. un signal non modulé du type en créneaux) présentant un déphasage programmable sur une large plage.

Plus particulièrement, il est proposé d'utiliser un oscillateur rotatif à ondes progressives, ou RTWO (pour « Rotary Traveling Wave Oscillator » en anglais), en anneau. En effet, la phase du signal d'oscillation au sein d'un tel oscillateur, lorsque observée en différents points d'observation couvrant l'ensemble de l'anneau, présente des variations permettant de couvrir l'ensemble du cercle trigonométrique. De même, l'amplitude du signal d'oscillation reste constante tout au long de l'anneau.

Par ailleurs, l'injection d'un signal de référence sur une cellule d'amplification donnée permet de verrouiller la phase du signal d'oscillation au sein de l'oscillateur, et donc la phase du (ou des) signal radiofréquences obtenu. De la sorte, la phase du signal d'oscillation observé en un point donné de l'anneau peut être contrôlée via le point d'injection du signal de référence dans l'anneau. Ceci est obtenu en configurant le dispositif multiplexeur pour injecter le signal de référence sur la (ou les) cellule d'amplification correspondant à la phase voulue.

Dans certains modes de réalisation, au moins une cellule amplificatrice d'entretien comprend une capacité variable.

Ainsi, la longueur radioélectrique de l'anneau, et donc la fréquence du (ou des) signal radiofréquences généré, est variable.

Dans certains modes de réalisation, les cellules amplificatrices sont équiréparties le long de l'anneau.

Ainsi, un incrément de phase constant du (ou des) signal radiofréquences est obtenu lorsque le signal de référence est injecté sur les différentes cellules amplificatrices.

Dans certains modes de réalisation, l'oscillateur comprend deux anneaux conducteurs. La pluralité de cellules amplificatrices comprend un nombre pair de cellules amplificatrices. Les cellules amplificatrices sont connectées électriquement aux deux anneaux selon un montage différentiel. Dans certains modes de réalisation, l'oscillateur comprend un unique anneau conducteur. La pluralité de cellules amplificatrices comprend un nombre impair de cellules amplificatrices. Les cellules amplificatrices sont connectées à l'anneau selon un montage asymétrique.

Dans certains modes de réalisation, le système est configuré pour générer le (ou les) signal radiofréquences verrouillé en phase lorsque la fréquence du signal de référence est égale à la fréquence du (ou des) signal radiofréquences ou à un sous-multiple entier de la fréquence du (ou des) signal radiofréquences.

Dans certains modes de réalisation, le dispositif multiplexeur programmable est configuré pour connecter électriquement le port d'entrée du système à une seule cellule amplificatrice sélectionnable parmi les cellules de la pluralité.

Dans certains modes de réalisation, le dispositif multiplexeur programmable est configuré pour connecter électriquement le port d'entrée du système à :
- une première cellule amplificatrice sélectionnable parmi les cellules de la pluralité ; et
- une deuxième cellule amplificatrice sélectionnable parmi les cellules de la pluralité.

La deuxième cellule est diamétralement opposée à la première cellule le long dudit au moins un anneau. Le signal de référence injecté au niveau de la deuxième cellule est inversé par rapport au signal de référence injecté au niveau de la première cellule.

Dans certains modes de réalisation, le système comprend en outre un modulateur sigma-delta délivrant un flux de mots binaires appartenant à un ensemble fini de mots binaires représentatifs de N valeurs numériques. Le dispositif multiplexeur programmable est configuré pour connecter électriquement, en fonction du flux de mots binaires, le port d'entrée du système à une des N cellules amplificatrices sélectionnables parmi les cellules de la pluralité. Les N cellules amplificatrices sont des cellules successives le long de l'anneau, chaque cellule amplificatrice parmi les N cellules amplificatrices étant associée à une valeur respective parmi les N valeurs numériques. Le signal de référence est injecté au niveau d'une cellule amplificatrice donnée parmi les N cellules amplificatrices lorsqu'un mot binaire délivré par le modulateur sigma-delta est représentatif d'une valeur correspondant à la valeur associée à la cellule amplificatrice donnée. Ainsi, de par l'effet passe-bas de l'oscillateur vis-à-vis du signal de référence injecté, on obtient un incrément de phase fractionnaire de l'incrément de phase obtenu lorsque le signal de référence est simplement injecté sur l'une quelconque des cellules amplificatrices.

Dans certains modes de réalisation, le système est configuré pour générer le (ou les) signal radiofréquences verrouillé en phase lorsque la fréquence du flux de mots binaires est égale à la fréquence du signal de référence ou à un sous-multiple entier de la fréquence du signal de référence.

Par exemple, la consommation du système est réduite lorsque la fréquence du flux de mots binaires est égale à un sous-multiple entier de la fréquence du signal de référence.

L'invention concerne également un émetteur radiofréquences comprenant :
- un synthétiseur de fréquences délivrant un signal de référence ;
- une pluralité de systèmes de génération tel que décrit ci-dessus (selon l'un quelconque des modes de réalisation précités). Chaque système génère au moins un signal radiofréquences respectif verrouillés en phase sur le signal de référence, le dispositif multiplexeur de chaque système étant programmé pour que les signaux radiofréquences générés par les différents systèmes de la pluralité présentent un gradient de phase relatif entre eux ;
- une pluralité de dispositifs de transposition en fréquences alimentés chacun à partir d'au moins un signal radiofréquences respectif et délivrant un signal à émettre respectif à partir d'un signal basses fréquences donné.

Ainsi, une formation de faisceau à l'émission est obtenue de manière simple et efficace.

L'invention concerne également un récepteur radiofréquences comprenant :
- un synthétiseur de fréquences délivrant un signal de référence ;
- une pluralité de systèmes de génération tel que décrit ci-dessus (selon l'un quelconque des modes de réalisation précités). Chaque système générant au moins un signal radiofréquences respectifs verrouillés en phase sur le signal de référence, le dispositif multiplexeur de chaque système étant programmé pour que les signaux radiofréquences générés par les différents systèmes de la pluralité présentent un gradient de phase relatif entre eux ;
- une pluralité de dispositifs de transposition en fréquences alimentés chacun à partir d'au moins un signal radiofréquences respectif et délivrant un signal basses fréquences respectif à partir d'un signal reçu.

Ainsi, une formation de faisceau à la réception est obtenue de manière simple et efficace.

### Liste des figures

D'autres buts, caractéristiques et avantages de l'invention apparaîtront plus clairement à la lecture de la description suivante, donnée à titre de simple exemple illustratif, et non limitatif, en relation avec les figures, parmi lesquelles :
[Fig.1] illustre un système de génération d'un signal radiofréquences verrouillé en phase sur un signal de référence selon un mode de réalisation de l'invention ;
[Fig.2] illustre un exemple de structure d'une cellule amplificatrice d'entretien implémentée dans le système de la [Fig.1] selon un mode de réalisation de l'invention ;
[Fig.3] illustre des exemples de phases de signaux radiofréquences obtenus pour une première et pour une deuxième configuration du dispositif multiplexeur programmable du système de la [Fig.1] ;
[Fig.4] illustre un système de génération d'un signal radiofréquences verrouillé en phase sur un signal de référence selon un autre mode de réalisation de l'invention ;
[Fig.5] illustre un émetteur radiofréquences comprenant une pluralité de systèmes de génération de signaux radiofréquences verrouillés en phase sur un signal de référence selon un mode de réalisation de l'invention ;
[Fig.6] illustre un récepteur radiofréquences comprenant une pluralité de systèmes de génération de signaux radiofréquences verrouillés en phase sur un signal de référence selon un mode de réalisation de l'invention.

### Description détaillée de modes de réalisation de l'invention

Le principe général de l'invention repose sur un système mettant en oeuvre un RTWO en anneau dans lequel un signal de référence peut être injecté en différents points de l'anneau. Le système est configuré pour que le RTWO génère un signal d'oscillation verrouillé en phase sur le signal de référence. Ainsi, la phase du signal d'oscillation, lorsque observée en différents points de l'anneau, présente des variations couvrant l'ensemble du cercle trigonométrique. De même, l'amplitude du signal d'oscillation reste constante le long de l'anneau.

Par ailleurs, la phase du signal d'oscillation observé en un point donné de l'anneau peut être contrôlée via le point d'injection du signal de référence dans l'anneau. Il en est ainsi de même pour au moins un signal radiofréquences généré en prélevant le signal d'oscillation en un point donné de l'anneau.

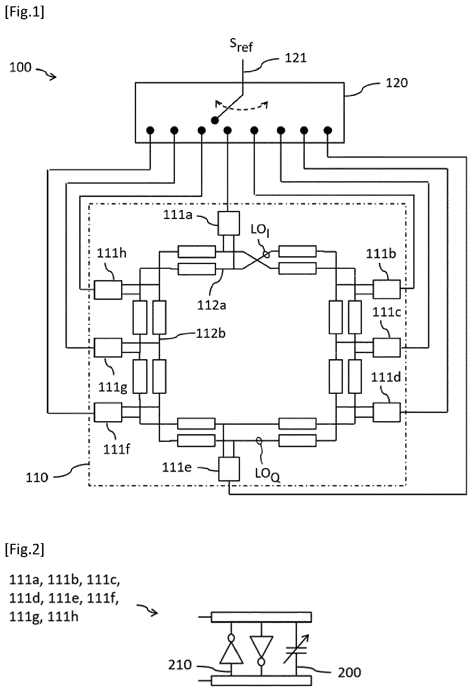

On présente désormais, en relation avec la [Fig.1] un système 100 de génération de deux signaux radiofréquences LO_{I}, LO_{Q}, verrouillés en phase sur un signal de référence S_{ref} selon un mode de réalisation de l'invention.

Plus particulièrement, le système 100 comprend :
- un RTWO 110 comprenant deux anneaux 112a, 112b conducteurs et huit cellules amplificatrices 111a, 111b, 111c, 111d, 111e, 111f, 111g, 111h, d'entretien connectées électriquement aux deux anneaux 112a, 112b ;
- un dispositif multiplexeur 120 programmable configuré pour connecter électriquement un port d'entrée 121 du système 100 à une cellule amplificatrice sélectionnable parmi les huit cellules amplificatrices 111a, 111b, 111c, 111d, 111e, 111f, 111g, 111h.

Le système est configuré pour que le RTWO 110 génère un signal d'oscillation différentiel verrouillé en phase sur le signal de référence S_{ref} lorsque le signal de référence S_{ref} est injecté sur le port d'entrée 121. L'écart de phase entre le signal d'oscillation et le signal de référence S_{ref} est fonction de la cellule amplificatrice 111a (ou 111b ou 111c ou 111d ou 111e ou 111f ou 111g ou 111h) à laquelle le port d'entrée 121 est électriquement connecté via la programmation du dispositif multiplexeur 120. Un tel phénomène de verrouillage en phase par injection est connu en soi.

Deux signaux radiofréquences LO_{I}, LO_{Q} sont générés en prélevant le signal d'oscillation en des points donnés respectifs des deux anneaux (ici des points diamétralement opposés). Cependant, dans d'autres modes de réalisation, un seul signal radiofréquences est généré en prélevant le signal d'oscillation en un point donné des deux anneaux. Dans d'autres modes de réalisation, plus de deux signaux radiofréquences sont générés en prélevant le signal d'oscillation en des points donnés respectifs des deux anneaux.

Par ailleurs, selon l'implémentation matérielle considérée, le système 100 est configuré pour générer le (ou les) signal radiofréquences verrouillé en phase lorsque la fréquence du signal de référence S_{ref} est égale à la fréquence du (ou des) signal radiofréquences ou à un sous-multiple entier de la fréquence du (ou des) signal radiofréquences.

Par exemple, le bruit de phase du (ou des) signal radiofréquences généré est égal au bruit de phase de la référence et non plus égal au bruit de phase propre de l'oscillateur lorsque la fréquence du signal de référence S_{ref} est égale à la fréquence du (ou des) signal radiofréquences.

Lorsque la fréquence du signal de référence S_{ref} est égale à un sous-multiple entier de la fréquence du (ou des) signal radiofréquences, le bruit de phase est alors égal au bruit de phase de la référence auquel est ajouté 20log(N), N étant le ratio entre la fréquence du signal et la fréquence du signal de référence S_{ref}.

De retour à la [Fig.1], les huit cellules amplificatrices 111a, 111b, 111c, 111d, 111e, 111f, 111g, 111h sont équiréparties le long des deux anneaux 112a, 112b. Ainsi, un incrément de phase constant des signaux radiofréquences LO_{I}, LO_{Q} est obtenu lorsque le signal de référence S_{ref} est injecté sur différentes cellules amplificatrices. Plus particulièrement, les conditions d'oscillation au sein du RTWO font que la phase du signal d'oscillation du RTWO 110, varie de 180 degrés lorsque observée en différents points d'observation couvrant tout le tour des anneaux 112a, 112b. Ainsi :
- lorsque le dispositif multiplexeur 120 est configuré pour connecter électriquement le port d'entrée 121 à une cellule amplificatrice donnée, e.g. la cellule 111a, on obtient une première phase des signaux radiofréquences LO_{I}, LO_{Q} générés ; et
- lorsque le dispositif multiplexeur 120 est configuré pour connecter électriquement le port d'entrée 121 à la cellule amplificatrice suivante de la cellule donnée le long des anneaux 112a, 112b, e.g. la cellule 111b, on obtient une deuxième phase des signaux radiofréquences LO_{I}, LO_{Q} générés.

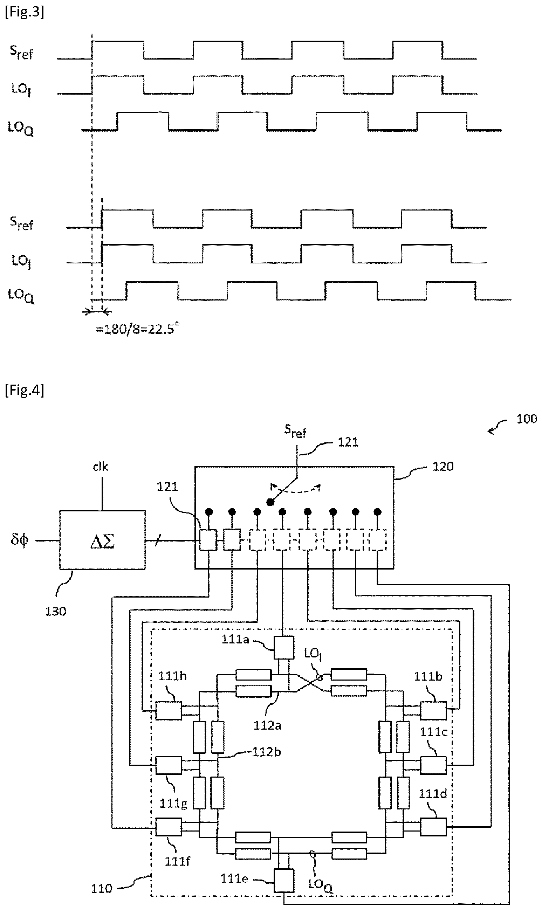

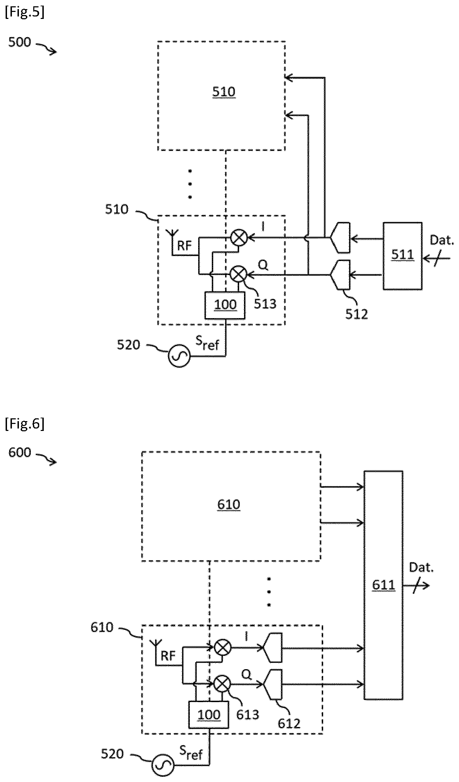

On observe alors que la différence de phase entre la deuxième phase et la première phase est égale à 180/8 = 22.5 degrés. Une telle configuration correspond aux signaux illustrés respectivement sur la partie haute et sur la partie basse de la [Fig.3]. Par ailleurs, les deux signaux radiofréquences LO_{I}, LO_{Q}, correspondant au signal d'oscillation observé en des points diamétralement opposés des deux anneaux 112a, 112b, présentent un écart de phase de 90 degrés. Les signaux LO_{I}, LO_{Q}, prélevés à de tels points diamétralement opposés des deux anneaux 112a, 112b, peuvent par exemple servir de signaux pour la transposition en fréquence en alimentant des mixers en quadrature comme discuté ci-dessous en relation avec la [Fig.5] et la [Fig.6].

Dans d'autres modes de réalisation, les cellules amplificatrices ne sont pas équiréparties le long des anneaux. Dans ce cas, un incrément de phase non constant du (ou des) signal radiofréquences est obtenu lorsque le signal de référence est injecté sur les différentes cellules amplificatrices.

De retour à la [Fig.1], la longueur radioélectrique des anneaux 112a, 112b chargés par l'impédance des cellules amplificatrices 111a, 111b, 111c, 111d, 111e, 111f, 111g, 111h correspond à la fréquence du signal d'oscillation obtenu au sein d'un tel oscillateur, et donc à la fréquence du (ou des) signal radiofréquences ainsi généré. Notamment, la partie capacitive de l'impédance en question influe sur la longueur radioélectrique des anneaux 112a, 112b chargés. Ainsi, dans certains modes de réalisation comme dans le mode de réalisation illustré sur la [Fig.2], une telle cellule amplificatrice 111a (ou 111b ou 111c ou 111d ou 111e ou 111f ou 111g ou 111h) comprend une capacité variable. Ainsi, la longueur radioélectrique des anneaux 112a, 112b, et donc la fréquence du (ou des) signal radiofréquences généré, est variable. Suivant les implémentations, tout ou partie des cellules 111a, 111b, 111c, 111d, 111e, 111f, 111g, 111h du système 100 comprend une telle capacité variable.

Par ailleurs, dans le mode de réalisation illustré sur la [Fig.2], la cellule amplificatrice 111a (ou 111b ou 111c ou 111d ou 111e ou 111f ou 111g ou 111h) comprend deux inverseurs 210 connectés électriquement et selon des polarités inversées aux deux anneaux 112a, 112b conducteurs du RTWO 110. Les deux inverseurs 210 implémentent la fonction amplificatrice d'entretien des oscillations du RTWO 110. Cependant, dans d'autres modes de réalisation d'autres structures amplificatrices connues sont mises en oeuvre afin d'implémenter la partie amplificatrice d'entretien des oscillations du RTWO 110.

De retour à la [Fig.1], le RTWO 110 comprend deux anneaux 112a, 112b conducteurs. De la sorte, le signal d'oscillation du RTWO 110, et donc le (ou les) signal radiofréquences généré également, est un signal différentiel. Ainsi, les cellules amplificatrices 111a, 111b, 111c, 111d, 111e, 111f, 111g, 111h sont connectées électriquement aux deux anneaux 112a, 112b selon un montage différentiel.

Par ailleurs, le RTWO 110 comprend huit cellules amplificatrices 111a, 111b, 111c, 111d, 111e, 111f, 111g, 111h. Mais de manière générale, dans de tels modes de réalisation dans lesquels le RTWO 110 comprend deux anneaux conducteurs, un nombre pair de cellules amplificatrices est implémenté. Les cellules amplificatrices sont connectées deux anneaux selon un montage différentiel.

Cependant, dans certains modes de réalisation, le RTWO 110 comprend un unique anneau 112a (ou 112b) conducteur. Un nombre impair de cellules amplificatrices est implémenté dans le RTWO 110. Les cellules amplificatrices sont connectées à l'anneau selon un montage asymétrique.

Dans certains modes de réalisation, le dispositif multiplexeur 120 programmable est configuré pour connecter électriquement le port d'entrée 121 du système 100 à une seule cellule amplificatrice sélectionnable parmi les cellules amplificatrices 111a, 111b, 111c, 111d, 111e, 111f, 111g, 111h.

Cependant, dans certains modes de réalisation dans lesquels le RTWO 110 comprend deux anneaux 112a, 112b conducteurs, les cellules amplificatrices étant connectées électriquement aux deux anneaux 112a, 112b selon un montage différentiel, le dispositif multiplexeur 120 programmable est configuré pour connecter électriquement le port d'entrée 121 du système 100 à :
- une première cellule amplificatrice sélectionnable parmi les cellules amplificatrices connectées électriquement aux deux anneaux 112a, 112b ; et
- une deuxième cellule amplificatrice sélectionnable parmi les cellules amplificatrices connectées électriquement aux deux anneaux 112a, 112b.

La deuxième cellule est diamétralement opposée à la première cellule le long des deux anneaux 112a, 112b. Le signal de référence S_{ref} injecté au niveau de la deuxième cellule est inversé par rapport au signal de référence S_{ref} injecté au niveau de la première cellule.

On présente désormais, en relation avec la [Fig.4] un système 100 de génération d'un signal radiofréquences verrouillé en phase sur un signal de référence S_{ref} selon un autre mode de réalisation de l'invention.

Plus particulièrement, le système 100 comprend les éléments décrits ci-dessus en relation avec la [Fig.1] (selon l'un quelconque des modes de réalisation précités). Le système 100 selon le présent mode de réalisation comprend en outre un modulateur sigma-delta 130 délivrant un flux de mots binaires appartenant à un ensemble fini de mots binaires représentatifs de N valeurs numériques (e.g. des valeurs numériques successives).

Le dispositif multiplexeur 120 programmable est configuré pour connecter électriquement, en fonction du flux de mots binaires, le port d'entrée 121 à N cellules amplificatrices sélectionnables parmi les cellules amplificatrices 111a, 111b, 111c, 111d, 111e, 111f, 111g, 111h du RTWO 110, les N cellules amplificatrices étant des cellules successives le long des deux anneaux 112a, 112b. N est ici un entier supérieur ou égal à deux.

Chaque cellule amplificatrice parmi les N cellules amplificatrices est associée à une valeur respective parmi les N valeurs numériques. Le signal de référence S_{ref} est injecté au niveau d'une cellule amplificatrice donnée parmi les N cellules amplificatrices lorsqu'un mot binaire délivré par le modulateur sigma-delta 130 est représentatif d'une valeur correspondant à la valeur associée à la cellule amplificatrice donnée.

Ainsi, les N cellules amplificatrices sont alimentées successivement par le signal de référence selon un ordre fonction du flux de mots binaires délivré par le modulateur sigma-delta 130. Pour ce faire, le dispositif multiplexeur 120 programmable comprend e.g. des interrupteurs 121. Un tel interrupteur 121 est commuté de sorte à être passant lorsqu'un mot binaire délivré par le modulateur sigma-delta 130 est représentatif d'une valeur correspondant à la valeur associée à la cellule amplificatrice alimentée par le signal contrôlé via l'interrupteur 121 en question.

Plus particulièrement, l'alimentation successive des N cellules amplificatrices fait osciller le déphasage entre différentes valeurs discrètes comprises entre deux valeurs extrêmes. Ainsi, la commutation étant suffisamment rapide entre les différentes cellules amplificatrices par rapport à la bande passante du phénomène d'injection au sein du RTWO 110, la phase du signal d'oscillation se stabilise à une valeur moyenne. En d'autres termes, de par l'effet passe-bas du RTWO 110 vis-à-vis du signal de référence S_{ref} injecté, on obtient ainsi un incrément de phase δ*φ* fractionnaire de l'incrément de phase obtenu lorsque le signal de référence S_{ref} est simplement injecté sur l'une quelconque des cellules amplificatrices.

Selon l'implémentation matérielle considérée, le système 100 est configuré pour générer le (ou les) signal radiofréquences verrouillé en phase lorsque la fréquence du flux de mots binaires délivré par le modulateur sigma-delta 130 est égale à la fréquence du signal de référence S_{ref} ou à un sous-multiple entier de la fréquence du signal de référence S_{ref}. Par exemple la fréquence du signal d'horloge clk alimentant le modulateur sigma-delta 130 est égale à la fréquence du signal de référence S_{ref} ou à un sous-multiple entier de la fréquence du signal de référence S_{ref}.

Par exemple, la consommation du système est réduite lorsque la fréquence du flux de mots binaires est égale à un sous-multiple entier de la fréquence du signal de référence S_{ref}. A contrario, une fréquence du flux de mots binaires importante, e.g. égale à la fréquence du signal de référence S_{ref}, permet de réduire l'impact de la présence du modulateur sigma-delta 130 sur le bruit de phase du signal radiofréquences généré. Dans ce dernier cas, selon certaines implémentations, le signal de référence S_{ref} injecté et le signal d'horloge clk alimentant le modulateur sigma-delta 130 sont synchrones. Ceci permet d'éviter des commutations entre les différentes cellules amplificatrices qui pourraient intervenir pendant une même phase du signal de référence S_{ref}.

On présente désormais, en relation avec la [Fig.5] un émetteur 500 radiofréquences comprenant une pluralité de systèmes 100 de génération de signaux radiofréquences verrouillés en phase sur un signal de référence S_{ref} selon un mode de réalisation de l'invention.

Plus particulièrement, un tel émetteur 500 comprend un synthétiseur 520 de fréquences délivrant le signal de référence S_{ref}. L'émetteur 500 comprend également une pluralité de chaines d'émission 510, chaque chaine d'émission 510 comprenant :
- un système 100 (selon l'un quelconque des modes de réalisations précités) pour la génération d'au moins un signal radiofréquences respectif verrouillé en phase sur le signal de référence S_{ref};
- un dispositif 513 de transposition en fréquences alimenté à partir du au moins un signal radiofréquences respectif et délivrant un signal à émettre respectif à partir d'un signal basses fréquences donné. Par exemple, le dispositif 513 met en oeuvre deux mixers en quadrature alimentés par des signaux radiofréquences LO_{I}, LO_{Q} générés par le système 100 comme décrit ci-dessus en relation avec la [Fig.1].

De retour à la [Fig.5], le dispositif multiplexeur 120 du système 100 de chaque chaine d'émission 510 est programmé pour que les différents signaux radiofréquences générés par les systèmes 100 des différentes chaines d'émission 510 présentent un gradient de phase relatif entre eux. De la sorte, une formation de faisceau à l'émission est obtenue de manière simple et efficace.

Par ailleurs, le signal basses fréquences donné est commun aux différentes chaines d'émission 510. Le signal basses fréquences en question véhicule les données numériques à transmettre. Un tel signal basses fréquences est par exemple généré selon une technique connue par un dispositif 511 de génération d'un signal modulant à partir de bits de données et converti dans le domaine analogique par des convertisseurs 512 numériques-analogiques.

On présente désormais, en relation avec la [Fig.6] un récepteur 600 radiofréquences comprenant une pluralité de systèmes 100 de génération de signaux radiofréquences verrouillés en phase sur un signal de référence S_{ref} selon un mode de réalisation de l'invention.

Plus particulièrement, un tel récepteur 600 comprend un synthétiseur 520 de fréquences délivrant le signal de référence S_{ref}. Le récepteur 600 comprend également une pluralité de chaines de réception 610, chaque chaine de réception 610 comprenant :
- un système 100 (selon l'un quelconque des modes de réalisations précités) pour la génération d'au moins un signal radiofréquence respectif verrouillé en phase sur le signal de référence S_{ref} ;
- un dispositif 613 de transposition en fréquences alimenté à partir du au moins un signal radiofréquences respectif et délivrant un signal basses fréquences respectif à partir d'un signal reçu. Par exemple, le dispositif 613 met en oeuvre deux mixers en quadrature alimentés par des signaux radiofréquences LO_{I}, LO_{Q} générés par le système 100 comme décrit ci-dessus en relation avec la [Fig.1].

De retour à la [Fig.6], le dispositif multiplexeur 120 du système 100 de chaque chaine de réception 610 est programmé pour que les différents signaux radiofréquences générés par les systèmes 100 des différentes chaines de réception 610 présentent un gradient de phase relatif entre eux. De la sorte, une formation de faisceau à la réception est obtenue de manière simple et efficace.

Par exemple, le signal basses fréquences délivré par le dispositif 613 de transposition en fréquences de chaque chaine de réception 610 est numérisé par des convertisseurs analogiquesnumériques 612 respectifs avant d'être démodulé par un dispositif 611 de démodulation mettant en oeuvre une technique de formation de faisceau d'un type connu.

## Revendications

1. Système (100) de génération d'au moins un signal radiofréquences verrouillé en phase sur un signal de référence, **caractérisé en ce qu'**il comprend :
- un oscillateur (110) rotatif à ondes progressives comprenant au moins un anneau (112a, 112b) conducteur et une pluralité de cellules amplificatrices (111a, 111b, 111c, 111d, 111e, 111f, 111g, 111h) d'entretien connectées électriquement audit au moins un anneau, une longueur radioélectrique de l'anneau chargé par une impédance des cellules amplificatrices correspondant à une fréquence dudit au moins un signal radiofréquences ;
- un dispositif multiplexeur (120) programmable configuré pour connecter électriquement un port d'entrée (121) du système à au moins une cellule amplificatrice sélectionnable parmi les cellules de la pluralité,
le système étant configuré pour que l'oscillateur génère un signal d'oscillation verrouillé en phase sur le signal de référence lorsque le signal de référence est injecté sur le port d'entrée du système, un écart de phase entre le signal d'oscillation et le signal de référence étant fonction de ladite au moins une cellule amplificatrice à laquelle le port d'entrée est électriquement connecté via la programmation du dispositif multiplexeur, ledit au moins un signal radiofréquences correspondant au signal d'oscillation prélevé en un point donné respectif dudit au moins un anneau.

2. Système selon la revendication 1, dans lequel au moins une cellule amplificatrice d'entretien comprend une capacité variable (200).

3. Système selon la revendication 1 ou 2, dans lequel les cellules amplificatrices sont équiréparties le long de l'anneau.

4. Système selon l'une quelconque des revendications 1 à 3, dans lequel l'oscillateur comprend deux anneaux conducteurs, la pluralité de cellules amplificatrices comprenant un nombre pair de cellules amplificatrices, les cellules amplificatrices étant connectées électriquement aux deux anneaux selon un montage différentiel.

5. Système selon l'une quelconque des revendications 1 à 3, dans lequel l'oscillateur comprend un unique anneau conducteur, la pluralité de cellules amplificatrices comprenant un nombre impair de cellules amplificatrices, les cellules amplificatrices étant connectées à l'anneau selon un montage asymétrique.

6. Système selon l'une quelconque des revendications 1 à 5, dans lequel le dispositif multiplexeur programmable est configuré pour connecter électriquement le port d'entrée du système à une seule cellule amplificatrice sélectionnable parmi les cellules de la pluralité.

7. Système selon la revendication 4, dans lequel le dispositif multiplexeur programmable est configuré pour connecter électriquement le port d'entrée du système à :
- une première cellule amplificatrice sélectionnable parmi les cellules de la pluralité ; et
- une deuxième cellule amplificatrice sélectionnable parmi les cellules de la pluralité, la deuxième cellule étant diamétralement opposée à la première cellule le long dudit au moins un anneau, le signal de référence injecté au niveau de la deuxième cellule étant inversé par rapport au signal de référence injecté au niveau de la première cellule.

8. Système selon l'une quelconque des revendications 1 à 5, comprenant en outre un modulateur sigma-delta (130) délivrant un flux de mots binaires appartenant à un ensemble fini de mots binaires représentatifs de N valeurs numériques,
dans lequel le dispositif multiplexeur programmable est configuré pour connecter électriquement, en fonction du flux de mots binaires, le port d'entrée du système à une des N cellules amplificatrices sélectionnables parmi les cellules de la pluralité, les N cellules amplificatrices étant des cellules successives le long de l'anneau, chaque cellule amplificatrice parmi les N cellules amplificatrices étant associée à une valeur respective parmi les N valeurs numériques, le signal de référence étant injecté au niveau d'une cellule amplificatrice donnée parmi les N cellules amplificatrices lorsqu'un mot binaire délivré par le modulateur sigma-delta est représentatif d'une valeur correspondant à la valeur associée à la cellule amplificatrice donnée.

9. Emetteur (500) radiofréquences **caractérisé en ce qu'**il comprend :
- un synthétiseur (520) de fréquences délivrant un signal de référence ;
- une pluralité de systèmes (100) selon l'une quelconque des revendications 1 à 8, chaque système générant au moins un signal radiofréquences respectif verrouillés en phase sur ledit signal de référence, le dispositif multiplexeur de chaque système étant programmé pour que les signaux radiofréquences générés par les différents systèmes de la pluralité présentent un gradient de phase relatif entre eux ;
- une pluralité de dispositifs (513) de transposition en fréquences alimentés chacun à partir d'au moins un signal radiofréquences respectif et délivrant un signal à émettre respectif à partir d'un signal basses fréquences donné.

10. Récepteur (600) radiofréquences **caractérisé en ce qu'**il comprend :
- un synthétiseur (520) de fréquences délivrant un signal de référence ;
- une pluralité de systèmes (100) selon l'une quelconque des revendications 1 à 8, chaque système générant au moins un signal radiofréquences respectifs verrouillés en phase sur ledit signal de référence, le dispositif multiplexeur de chaque système étant programmé pour que les signaux radiofréquences générés par les différents systèmes de la pluralité présentent un gradient de phase relatif entre eux ;
- une pluralité de dispositifs (613) de transposition en fréquences alimentés chacun à partir d'au moins un signal radiofréquences respectif et délivrant un signal basses fréquences respectif à partir d'un signal reçu.
